# EUROPÄISCHE PATENTANMELDUNG

(11) **EP 0 607 836 A2**
(43) Veröffentlichungstag der Anmeldung: **27.07.1994**
(21) Anmeldenummer: 94100280.0
(22) Anmeldetag: 11.01.1994
(51) Int. Cl.: H01L 21/331, H01L 29/73

(54) **Verfahren zur Herstellung von Silizium-Germanium-Heterobipolartransistoren**

(30) Priorität: 20.01.1993 DE 4301333
(71) Anmelder: TEMIC TELEFUNKEN microelectronic GmbH, D-74072 Heilbronn (DE); Daimler-Benz Aktiengesellschaft, D-70546 Stuttgart (DE)
(72) Erfinder: Dietrich, Harry, D-74912 Kirchardt (DE); Gruhle,Andreas Dr., D-89081 Ulm (DE)
(74) Vertreter: Maute, Hans-Jürgen, Dipl.-Ing.

(57) **Zusammenfassung**

Beschrieben wird ein Verfahren zur Herstellung von integrierten Silizium-Germanium-Heterobipolartransistoren mit einer Silizium-Kollektorschicht, einer Silizium-Germanium-Basisschicht, einer Silizium-Emitterschicht und einer Silizium-Emitteranschlußschicht. Folgende Verfahrensschritte sind vorgesehen:
a) Kollektorschicht, Basisschicht, Emitterschicht und Emitteranschlußschicht werden mittels eines einzigen unterbrechungsfreien Prozesses abgeschieden und gleichzeitig dotiert,
b) seitlich der Basisschicht wird ein Basisanschlußgebiet derart gebildet, daß die Schnittflächen der Basis-Emitter-PN-Grenzschicht und der Basis-Kollektor-PN-Grenzschicht mit der Oberfläche der Halbleiteranordnung außerhalb der Silizium-Germanium-Basisschicht liegen,
c) auf der gesamten freiliegenden Silizium-Oberfläche der Halbleiteranordnung wird eine Siliziumdioxidschicht durch thermische Oxidation ausgebildet.

## Beschreibung

Neben Gallium-Arsenid-Transistoren werden Silizium-Germanium-Heterobipolartransistoren (SiGe-HBTs) in zunehmendem Maße für Anwendungen im Höchstfrequenzbereich (bsp. in der Kommunikationstechnik oder in Satelliten-Schaltkreisen) eingesetzt. Vorzugsweise werden integrierte NPN-Transistoren mit der Schichtenfolge N-Si-Kollektorschicht, P-SiGe-Basisschicht, N-Si-Emitterschicht und N⁺-Si-Emitteranschlußschicht verwendet, wobei die - aufgrund der unterschiedlichen Gitterkonstanten von Silizium (Si) und Silizium-Germanium (SiGe) - verspannte dünne SiGe-Basisschicht (Schichtdicke ca. 30-80 nm) für die Funktionsweise und die Eigenschaften des Transistors von entscheidender Bedeutung ist.

Hergestellt wird die Halbleiteranordnung der SiGe-HBTs meist mittels Epitaxieverfahren (Gasphasenepitaxie/CVD, Molekularstrahlepitaxie/MBE) oder mittels Implantationsverfahren. Probleme treten beim Herstellungsprozeß insbesondere dadurch auf, daß
- die Prozeßtemperatur bestimmte Werte nicht überschreiten darf (typischerweise 700 °C), um eine Relaxation der verspannten SiGe-Schicht zu vermeiden,
- durch jede Unterbrechung beim Wachstum der Schichtstruktur (Kollektor, Basis, Emitter, Emitteranschluß) einerseits ein Hochtemperatur-Reinigungsvorgang erforderlich gemacht wird (Gefahr der Relaxation der SiGe-Schicht) und andererseits die empfindliche - dann freiliegende, d.h. nicht abgedeckte - Emitter-Basis-Grenzfläche bzw. Basis-Kollektor-Grenzfläche kontaminiert wird,
- eine Dotierung der Halbleiterschichten nach der Herstellung der Schichtstruktur Schwierigkeiten bereitet: zum einen kann die Forderung, daß die Si/SiGe-Grenzflächen einerseits und die PN-Übergänge andererseits zur Vermeidung nachteiliger Bauelementeeigenschaften exakt übereinstimmen müssen, nur schwerlich oder gar nicht erfüllt werden; zum andern treten beim Einbringen der Dotierstoffe in die Halbleiterschichten nicht-tolerable Schäden auf, die einen zusätzlichen Ausheil-Prozeßschritt erforderlich machen, der wiederum mit unerwünschten Diffusionsprozessen verbunden ist,
- bei der Herstellung der Anschlußschichten bzw. der Anschlußkontakte die abgeschiedenen Halbleiterschichten wieder teilweise entfernt werden müssen; hierbei werden unpassivierte Si- oder SiGe-Oberflächen gebildet, die das Entstehen von Leckströmen stark begünstigen - eine nachträgliche Passivierung dieser Oberflächen kann nur sehr schwierig durchgeführt werden und die Leckströme nicht völlig unterdrücken.

Der Erfindung liegt die Aufgabe zugrunde, ein Verfahren zur Herstellung von integrierten Silizium-Germanium-Heterobipolartransistoren gemäß dem Oberbegriff des Anspruchs 1 anzugeben, bei dem die genannten Probleme vermieden werden und das günstige bzw. verbesserte Bauelementeeigenschaften der hergestellten Transistoren gewährleistet.

Diese Aufgabe wird erfindungsgemäß durch die Merkmale im Kennzeichen des Patentanspruchs 1 gelöst.

Vorteilhafte Weiterbildungen des Verfahrens ergeben sich aus den Unteransprüchen.

Beim vorgestellten Silizium-Germanium-Heterobipolartransistor wird
a) die Herstellung der kompletten Schichtstruktur des HBTs - das Schichtwachstum (Kollektorschicht, Basisschicht, Emitterschicht, Emitteranschlußschicht) einschließlich der Dotierung der Schichten - mit einem einzigen unterbrechungsfreien Prozeß durchgeführt (beispielsweise mittels MBE oder CVD); dadurch kann eine Kontamination zwischen den kritischen Transistorschichten ausgeschlossen werden.
   Während des Schichtwachstums ist kein Hochtemperatur-Reinigungsprozeß notwendig, so daß die verspannte SiGe-Schicht nicht relaxieren kann; da keine nachträgliche Dotierung der Halbleiterschichten erforderlich ist, entfallen die durch Diffusionsprozesse oder Implantationsprozesse verursachten Probleme.
b) ein Basisanschlußgebiet gebildet und eine Doppel-Mesastruktur der Halbleiteranordnung derart herausgebildet, daß die beiden PN-Übergänge im Bereich des Basisanschlußgebiets (Basis-Emitter-PN-Übergang bzw. Basis-Kollektor-PN-Übergang) oberhalb bzw. unterhalb der SiGe-Schicht (der Basis-Emitter-Grenzschicht bzw. der Basis-Kollektor-Grenzschicht) liegen.
   Hierzu wird zunächst durch einen (Stufen-) Ätzschritt unter Verwendung einer Hilfsschicht ein Teilbereich der Emitteranschlußschicht entfernt - die SiGe-Schicht bleibt jedoch unter der Si-Emitterschicht "vergraben", so daß kein Silizium-Germanium an der Oberfläche zu liegen kommt.
   Anschließend wird ein Implantationsprozeß durchgeführt (beispielsweise selbstjustiert mittels einer ersten Spacer-Oxidschicht), durch die einerseits die freiliegende Emitterschicht umdotiert wird (zum Basisanschlußgebiet gemacht wird) und andererseits der externe Basis-Kollektor-PN-Übergang geringfügig in die Si-Schicht unterhalb der SiGe-Schicht bzw. unter die Basis-Kollektor-Grenzschicht verschoben wird. Zum einen kann durch die Selbstjustierung der Abstand von Basisanschlußgebiet zu Emitteranschlußschicht sehr gering (minimal) gehalten werden, so daß auch der Basisbahnwiderstand minimiert wird (dies ist vorteilhaft für gute HF-Eigenschaften des Bauelements); zum andern liegen die Stellen, an denen die PN-Übergänge an die Oberfläche treten, in der Siliziumschicht und berühren nicht das Silizium-Germanium.
   Schließlich wird zur Ausbildung einer Mesastruktur durch einen zweiten (Mesa-) Ätzschritt unter Zuhilfenahme einer Maske ein Teilbereich des Basisanschlußgebiets und der Kollektorschicht selektiv abgetragen; weiterhin werden Feldoxidgebiete zur Separierung der aktiven Strukturen der Integrierten Schaltung herausgebildet.
c) durch thermische Oxidation auf der gesamten freiliegenden Oberfläche der Halbleiteranordnung eine qualitativ hochwertige Siliziumdioxidschicht gebildet, wodurch die an der Oberfläche liegenden und nicht die Silizium-Germanium-Schicht berührenden PN-Übergänge sehr effektiv geschützt (passiviert) werden und nur geringe Leckströme auftreten.
d) mit einem zweiten selbstjustierenden Prozeßschritt der Basis-Anschlußkontakt so nah wie möglich an die innere Basiszone herangebracht.
   Unter Zuhilfenahme einer zweiten Spacer-Oxidschicht - diese ist breiter als diejenige beim ersten selbstjustierenden Prozeßschritt - wird dieser Abstand selbstjustiert und minimiert.

Die Bauelemente-Eigenschaften eines mit dem vorgestellten Verfahren hergestellten SiGe-HBTs werden verbessert, da
- die eingangs beschriebenen Nachteile beim Herstellungsprozeß vermieden werden,
- die Halbleiteranordnung selbstjustiert unter Verwendung von Spacern hergestellt wird,
- die Dimensionen des Bauelements reduziert werden können,
- das Bauelement auch in einer integrierten Schaltung seine günstigen (HF-) Eigenschaften beibehält.

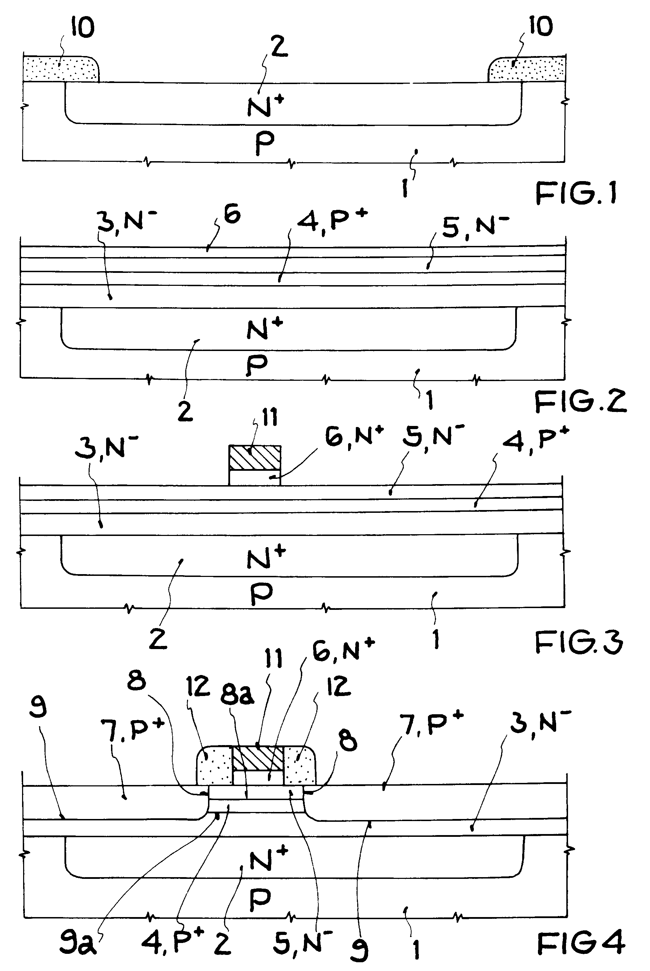

Weiterhin soll die Erfindung anhand eines Ausführungsbeispiels näher erläutert werden; in den Figuren 1-8 sind dazu verschiedene Prozeßschritte beim Herstellungsverfahren eines NPN-Silizium-Germanium-Heterobipolartransistors mit einer P-Silizium-Germanium-Basisschicht dargestellt.
- Figur 1:: Auf der Oberfläche einer P-dotierten Silizium-Substratscheibe 1 wird durch thermische Oxidation eine (Maskier-) Oxidschicht 10 gebildet und mittels Fotolack strukturiert; die N⁺-Kollektoranschlußschicht 2 ("buried layer") wird durch Implantation und Nachdiffusion von Arsen-Ionen gebildet.
- Figur 2:: Nach dem Entfernen der Maskier-Oxidschicht 10 wird die Schichtenfolge des SiGe-HBTs in einem einzigen Prozeß (beispielsweise mittels Molekularstrahlepitaxie MBE) ohne Unterbrechung bei gleichzeitiger Dotierung der Schichten gewachsen. Die Schichtenfolge umfaßt die N⁻-Kollektorschicht 3 (bsp. mit einer Schichtdicke von 300 nm und einer Dotierungskonzentration von 10¹⁶ bis 10¹⁷ cm⁻³), die P⁺-SiGe-Basisschicht 4 (Germaniumanteil beispielsweise 20 %, Schichtdicke 50 nm und Dotierungskonzentration 10¹⁹ cm⁻³), die N⁻-Emitterschicht 5 (bsp. mit einer Schichtdicke von 100 nm und einer Dotierungskonzentration von 10¹⁸ cm⁻³) sowie die N⁺-Emitteranschlußschicht 6 (bsp. Schichtdicke 50 nm und Dotierungskonzentration größer 10²⁰ cm⁻³).
- Figur 3:: Auf die N⁺-Emitteranschlußschicht 6 wird ganzflächig (beispielsweise durch ein CVD-Verfahren) eine Hilfsschicht 11 (beispielsweise aus Siliziumnitrid Si₃N₄) mit einer Schichtdicke von ca. 0,3 µm abgeschieden und mittels Fotolack strukturiert; ein Teilbereich der Si₃N₄-Hilfsschicht 11 und der Si-Emitteranschlußschicht 6 wird anisotrop abgeätzt - die Emitterschicht 5 verbleibt weiterhin über der SiGe-Basisschicht 4.
- Figur 4:: Auf die Oberfläche der Halbleiteranordnung wird ein CVD-Oxid (TEOS) 12 (beispielsweise mit einer Schichtdicke von 0,3 µm) konform abgeschieden und derart anisotrop rückgeätzt, daß nur an den senkrechten Kanten der Hilfsschicht 11 und der Emitteranschlußschicht 6 eine Oxidschicht 12 (Spacer) verbleibt und die restliche Oberfläche (für den Basisanschluß) freigelegt wird; in die freiliegende Oberfläche werden BF₂-Ionen (Dosis beispielsweise 4 x 10¹⁵ cm⁻², Beschleunigungsspannung beispielsweise 40 - 80 keV) bis in eine Tiefe knapp unterhalb der SiGe-Basisschicht 4 implantiert und dadurch das seitlich der Oxidspacer 12 liegende Emittergebiet 5 zum P⁺-Basisanschlußgebiet 7 umdotiert sowie der Basis-Kollektor-PN-Übergang 9 unter die Basis-Kollektor-Grenzschicht 9a und der Emitter-Basis-PN-Übergang 8 unter die Spacer-Oxidschicht 12 verschoben.

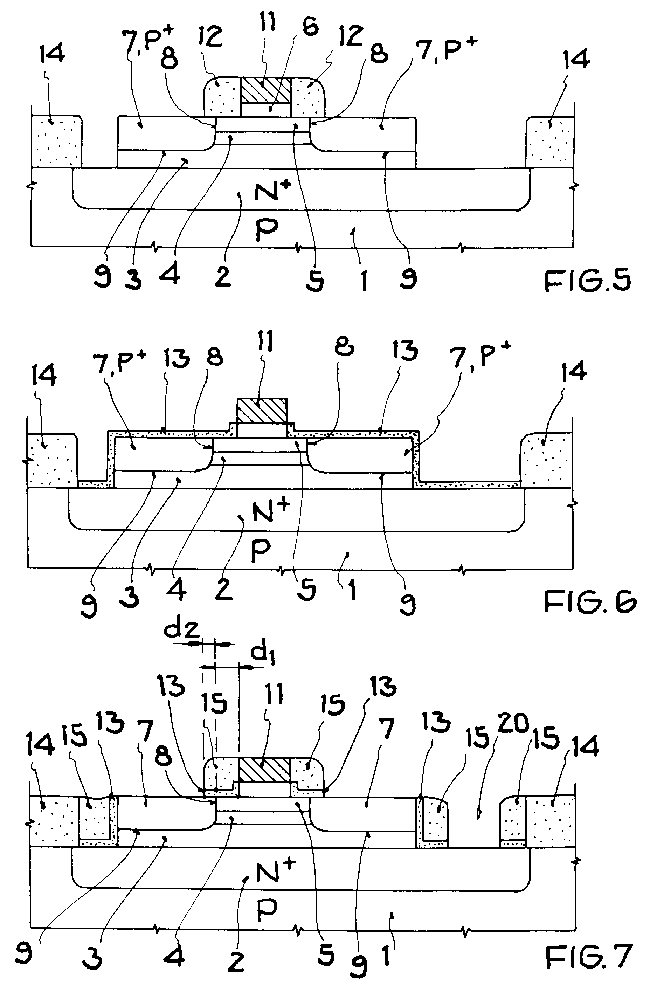

- Figur 5:: Die endgültige Mesastruktur wird herausgebildet, indem Basisanschlußgebiet 7 und Kollektorschicht 3 durch anisotropes Ätzen strukturiert werden; durch Abscheidung und Strukturierung eines CVD-Oxids (Schichtdicke beispielsweise 0,5 µm) werden Feldoxidgebiete 14 gebildet, die die einzelnen Bauelemente bzw. aktiven Strukturen der Integrierten Schaltung voneinander separieren.
- Figur 6:: Durch thermische Oxidation bei einer Temperatur von beispielsweise 700 °C wird die freiliegende Oberfläche der Halbleiteranordnung mit einer beispielsweise 10 nm-dicken SiO₂-Schicht 13 überzogen. Sowohl der Basis-Emitter-PN-Übergang 8 als auch der Kollektor-Basis-PN-Übergang 9 werden an der Oberfläche passiviert und somit vor Leckströmen geschützt.
- Figur 7:: Auf die Oberfläche der Halbleiteranordnung wird ganzflächig ein CVD-Oxid 15 (TEOS) abgeschieden (bsp. mit einer Schichtdicke von 0,5 µm) und derart anisotrop rückgeätzt, daß zum einen die Kollektor-Kontaktöffnung 20 gebildet wird und zum andern Oxidspacer 15 verbleiben, die die Oberfläche des Basis-Emitter-PN-Übergangs 8 über eine Länge d₂ schützen.
Die Abstände d₁ (vom Rand der Emitteranschlußschicht 6 bis zum Basisanschlußgebiet 7) und d₂ (vom Basisanschlußgebiet 7 bis zum späteren Basis-Metall 16) werden durch die beschriebene Spacertechnik unter Verwendung der Oxidschichten 12 und 15 selbstjustiert und minimal.

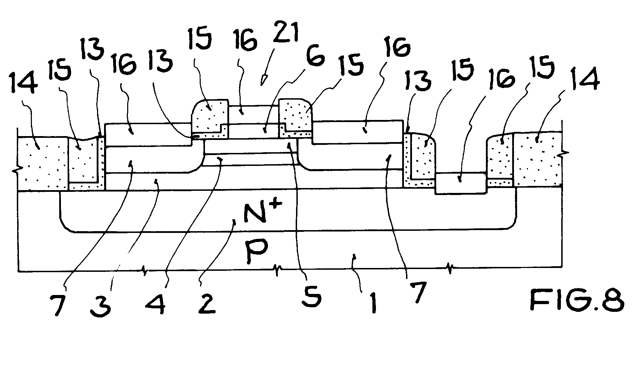

- Figur 8:: Der restliche Teil der Si₃N₄-Hilfsschicht 11 wird entfernt, und die Emitter-Kontaktöffnung 21 freigelegt. Durch Aufdampfen einer Metallschicht 16 (beispielsweise Titan) und deren Temperaturbehandlung wird auf der Oberfläche der Silizium-Bereiche 2, 6, 7 ein Metall-Silizid (bsp. Titan-Silizid) gebildet, während auf der Oberfläche der Oxidbereiche 13, 14, 15 das reine Metall verbleibt; die Metallschicht über den Oxidbereichen 13, 14, 15 wird mittels einer Ätzlösung selektiv entfernt.
Anschließend kann nach Aufbringen einer Oxidschicht und Herstellung von Kontaktöffnungen für Emitter, Basis und Kollektor eine Metallisierung mittels üblicher Verfahren aufgebracht werden.

Derartige SiGe-HBTs können jedoch nicht nur wie dargestellt auf einfach strukturierten Substraten gefertigt werden, sondern beispielsweise auch auf Substraten, die bereits fertige Bauelemente in reiner Silizium-Technologie (bsp. MOS oder Bipolar) enthalten.

## Patentansprüche

1. Verfahren zur Herstellung von integrierten Silizium-Germanium-Heterobipolartransistoren mit einer Silizium-Kollektorschicht (3), einer Silizium-Germanium-Basisschicht (4), einer Silizium-Emitterschicht (5) und einer Silizium-Emitteranschlußschicht (6), gekennzeichnet durch die Verfahrensschritte:
a) Kollektorschicht (3), Basisschicht (4), Emitterschicht (5) und Emitteranschlußschicht (6) werden mittels eines einzigen unterbrechungsfreien Prozesses abgeschieden und gleichzeitig dotiert,
b) seitlich der Basisschicht (4) wird ein Basisanschlußgebiet (7) derart gebildet, daß die Schnittflächen der Basis-Emitter-PN-Grenzschicht (8) und der Basis-Kollektor-PN-Grenzschicht (9) mit der Oberfläche der Halbleiteranordnung außerhalb der Silizium-Germanium-Basisschicht (4) liegen,
c) auf der gesamten freiliegenden Oberfläche der Halbleiteranordnung wird eine Siliziumdioxidschicht (13) durch thermische Oxidation ausgebildet.

2. Verfahren nach Anspruch 1, dadurch gekennzeichnet, daß eine Spacer-Oxidschicht (15) derart gebildet wird, daß ein definierter Abstand (d₂) zwischen Basis-Kontaktöffnung (22) und Basis-Emitter-PN-Übergang (8) entsteht, daß durch selektives Entfernen einer Hilfsschicht (11) unter Beibehalten der Spacer-Oxidschicht (15) die Emitteranschlußschicht (6) für einen selbstjustierten Emitter-Anschlußkontakt geöffnet wird, und daß Basis-Anschluß-Kontakt (B) und Emitter-Anschlußkontakt (E) gleichzeitig durch einen selbstjustierenden Silizid-Prozeß gebildet werden.

3. Verfahren nach Anspruch 1, dadurch gekennzeichnet, daß der Prozeß zur Abscheidung und Dotierung der Halbleiterschichten (3, 4, 5, 6) als CVD-Verfahren oder MBE-Verfahren durchgeführt wird.

4. Verfahren nach Anspruch 1, dadurch gekennzeichnet, daß das Basisanschlußgebiet (7) durch Implantation von Ionen in die Oberfläche der Emitterschicht (5) gebildet wird, und daß die Ionen derart implantiert werden, daß sich das Basisanschlußgebiet (7) bis unterhalb der Silizium-Germanium-Basisschicht (4) erstreckt.

5. Verfahren nach Anspruch 4, dadurch gekennzeichnet, daß die Emitteranschlußschicht (6) oberhalb des Basisanschlußgebiets (7) entfernt wird.

6. Verfahren nach Anspruch 4, dadurch gekennzeichnet, daß der Abstand (d₁) zwischen Basisanschlußgebiet (7) und Emitteranschlußschicht (6) selbstjustierend und minimal ausgebildet wird, wobei
a) eine Hilfsschicht (11) ganzflächig auf der Emitteranschlußschicht (6) abgeschieden wird,
b) Hilfsschicht (11) und Emitteranschlußschicht (6) strukturiert werden, indem ein Teilbereich der Hilfsschicht (11) und der Emitteranschlußschicht (6) abgetragen wird,
c) auf die Oberfläche der Halbleiteranordnung eine Oxidschicht ganzflächig abgeschieden und strukturiert wird, so daß eine Spacer-Oxidschicht (12) verbleibt,
d) die Hilfsschicht (11) und die Spacer-Oxidschicht (12) zur Maskierung für die Ionen-Implantation dienen.

7. Verfahren nach Anspruch 1, dadurch gekennzeichnet, daß durch Ätzen eines Teilbereichs des Basisanschlußgebiets (7) und der Kollektorschicht (3) eine Mesastruktur der Halbleiteranordnung herausgebildet wird.

8. Verfahren nach Anspruch 1, dadurch gekennzeichnet, daß der Transistorbereich ohne Mesa-Ätzung durch selektive Abscheidung der Halbleiterschichten in einem Oxidfenster definiert wird.

9. Verfahren nach Anspruch 1, dadurch gekennzeichnet, daß die Siliziumdioxidschicht (13) durch Oxidation des Halbleitermaterials gebildet wird.

10. Verfahren nach Anspruch 2, dadurch gekennzeichnet, daß eine Metallschicht (16) unter Verwendung der Spacer-Oxidschicht (15) ganzflächig aufgebracht und selbstjustiert strukturiert wird, und daß die zweite Spacer-Oxidschicht (15) breiter als die erste Spacer-Oxidschicht (12) ausgebildet wird.

11. Verfahren nach Anspruch 10, dadurch gekennzeichnet, daß zur Bildung der strukturierten Metallschicht (16)
a) auf der Oberfläche der Halbleiteranordnung ganzflächig eine Oxidschicht abgeschieden wird
b) die Oxidschicht derart selektiv geätzt wird, daß seitlich der Hilfsschicht (11) jeweils ein Teilbereich der Oxidschicht als zweite Spacer-Oxidschicht (15) verbleibt,
c) die Hilfsschicht (11) entfernt wird,
d) die Metallschicht (16) ganzflächig auf der Oberfläche der freiliegenden Silizium- und Siliziumoxid-Bereiche abgeschieden wird,
e) nach der Silizidierung der Metallschicht über den Silizium-Bereichen die Metallschicht (16) selektiv von der Oberfläche der Siliziumoxid-Bereiche entfernt wird.

12. Verfahren nach einem der Ansprüche 1 bis 11 zur Herstellung von integrierten NPN-Silizium-Germanium-Heterobipolartransistoren.
